Europäisches Patentamt

European Patent Office

Office européen des brevets

(19)

(11)  EP 0 803 709 B1

## (12) FASCICULE DE BREVET EUROPEEN

(45) Date de publication et mention
de la délivrance du brevet:
**14.11.2001   Bulletin 2001/46**

(51) Int Cl.⁷: **G01D 5/20**, H03M 1/64

(21) Numéro de dépôt: **97400934.2**

(22) Date de dépôt: **24.04.1997**

(54) **Dispositif de mesure de grandeur représentée par ses fonctions trigonométriques**

Vorrichtung zur Messung eines durch trigonometrische Funktionen dargestellten Parameters

Device for measuring a value which is represented by trigonometric functions

(84) Etats contractants désignés:
**DE FR GB**

(30) Priorité:  **26.04.1996  FR 9605314**

(43) Date de publication de la demande:
**29.10.1997   Bulletin 1997/44**

(73) Titulaire: **SAGEM SA**
**75016 Paris (FR)**

(72) Inventeurs:
 • **Rochereau, Jacques**
  **95100 Argenteuil (FR)**
 • **Leger, Pierre**
  **92130 Issy Les Moulineaux (FR)**
 • **Renault, Alain**
  **95300 Pontoise (FR)**

(74) Mandataire: **Fort, Jacques et al**
**CABINET PLASSERAUD**
**84, rue d'Amsterdam**
**75440 Paris Cedex 09 (FR)**

(56) Documents cités:
**US-A- 5 189 353**

 • **EDN ELECTRICAL DESIGN NEWS, vol. 34, no. 6, 16 mars 1989, pages 149-154, 156, XP000112415 SMITH F W: "DYNAMIC MODES REFINE SYNCHRO-TO-DIGITAL CONVERTER TESTING"**
 • **CONTROL IN POWER ELECTRONICS, BRIGHTON, SEPT. 13 - 16, 1993, vol. 4, 13 septembre 1993, INSTITUTION OF ELECTRICAL ENGINEERS, pages 472-477, XP000427120 MURRAY B A ET AL: "A DIGITAL TRACKING R/D CONVERTER WITH HARDWARE ERROR CALCULATION USING A TMS320C14"**

## Description

La présente invention a pour objet un dispositif de mesure à sortie numérique, destiné à recevoir deux signaux analogiques d'entrée représentant un vecteur de la forme

$$\eta = (\cos(\omega_0 t + \theta), \sin(\omega_0 t + \theta))$$

où $\omega_0$ est une pulsation et $\theta$ une phase.

La présente invention a aussi pour objet un dispositif de mesure à sortie numérique, destiné à recevoir deux signaux analogiques d'entrée représentant un vecteur de la forme

$$\eta = (\cos \omega_0 t \cos \theta, \cos \omega_0 t \sin \theta)$$

où $\omega_0$ est une pulsation et $\theta$ la phase à coder numériquement.

Dans les dispositifs de mesure habituels, les grandeurs analogiques sont numérisés par des convertisseurs analogique-numérique, en abrégé CAN, et les sorties des convertisseurs sont appliquées à un organe de calcul numérique.

Cette solution présente des inconvénients lorsqu'on cherche à obtenir une résolution élevée. Les CAN ayant un pas de quantification faible et/ou une cadence d'échantillonnage élevée, nécessaire à une bande passante large, sont très coûteux.

L'article de B.A. Murray et al.: "A Digital Tracking R/D Converter with Hardware Error Calculation Using TMS 32C 14" dans Control in Power Electronics, Brighton, 13. - 16. Septembre 1993, vol. 4, 13. Septembre 1993, Institution of Electrical Engineers, fait connaître un dispositif de mesure à sortie numérique destiné à recevoir deux signaux analogiques d'entrée de la forme $\sin\omega_0 t \cos\Theta$ et $\sin\omega_0 t \sin\Theta$ utilisant un convertisseur tension/fréquence.

L'invention vise à fournir un dispositif de mesure répondant mieux que ceux antérieurement connus aux exigences de la pratique, notamment ce ce qu'il ne met en oeuvre que des moyens simples.

Dans ce but, l'invention propose notamment un dispositif comprenant au moins un ensemble ayant :

- un convertisseur tension/fréquence ayant une plage de fonctionnement contenant la fréquence $N.\omega_0/2\pi$, où $N$ est un entier positif,
- un diviseur ayant des étages successifs en cascade, recevant le signal de sortie du convertisseur à une fréquence $f_1$ et fournissant deux composantes en phase et en quadrature u et v, prenant les valeurs 0 et 1, à la fréquence du convertisseur divisée par N,
- un multiplieur vectoriel du signal d'entrée $\eta$ par $\hat{\eta}$ de composantes :

$$u' = 2u-1, \quad v' = 2v-1,$$

- une boucle d'asservissement de la fréquence $f_1$ du convertisseur à partir d'une tension constituant un signal d'erreur apparaîssant à la sortie du multiplieur vectoriel, les sorties des étages successifs de la cascade fournissant une représentation numérique de $\omega_0 t + \theta$, avec une résolution $2\pi/N$. Etant donné que u et v prennent alternativement les valeurs 0 et 1, le changement permet de disposer de valeurs u' et v' qui peuvent prendre les valeurs +1 et -1.

Un dispositif de mesure permettant de fournir $\theta$, à condition que sa fréquence angulaire de variation soit lente par rapport à $\omega_0$, comprend un ensemble tel que défini ci-dessus et un second ensemble qui peut être identique au premier, avec une valeur opposée de $\omega_0$, ainsi qu'un additionneur ou soustracteur recevant les sorties des étages correspondants des deux diviseurs.

On voit que ce dispositif traite les signaux analogiques tels qu'ils sont reçus, ce qui semble a priori impliquer des calculs beaucoup plus lourds qu'un filtrage et une numérisation suivis d'un calcul numérique. En fait, on arrive à un dispositif qui ne comporte que des composants logiques ou arithmétiques simples en plus du convertisseur tension-fréquence.

Lorsqu'on souhaite obtenir une valeur numérique de $(\omega_0 t + \theta)$ représentée par un nombre binaire, on utilisera une cascade constituée de diviseurs par deux. Dans d'autres cas, par exemple si on souhaite obtenir une valeur de $(\omega_0 t + \theta)$ en degrés, minutes et secondes, on utilisera des étages effectuant une division par des facteurs différents.

Les caractéristiques ci-dessus ainsi que d'autres apparaîtront mieux à la lecture de la description qui suit d'un mode particulier de réalisation donné à titre d'exemple non limitatif. Cette description se réfère aux dessins qui l'accompagnent, dans lesquels :

- la figure 1 est un schéma de principe d'un dispositif simple de mesure numérique de la valeur d'un angle $\omega_0 t + \theta$ à partir de signaux analogiques représentant des fonctions trigonométriques sinus et cosinus ;
- la figure 2 est un synoptique montrant une constitution possible des composants de la figure 1 permettant de mesurer une position angulaire instantanée $\omega_0 t + \theta$ à partir des grandeurs $\cos(\omega_0 t + \theta)$ et $\sin(\omega_0 t + \theta)$ ;
- la figure 3, similaire à la figure 1, montre un dispositif comprenant deux ensembles et permettant de mesurer une position angulaire instantanée $\theta$ à partir des grandeurs $\cos \omega_0 t \cos\theta$ et $\cos \omega_0 t \sin \theta$ ;
- la figure 4 montre une variante de réalisation de la figure 3 ;
- la figure 5 montre le mode d'évaluation de $\theta$ à la

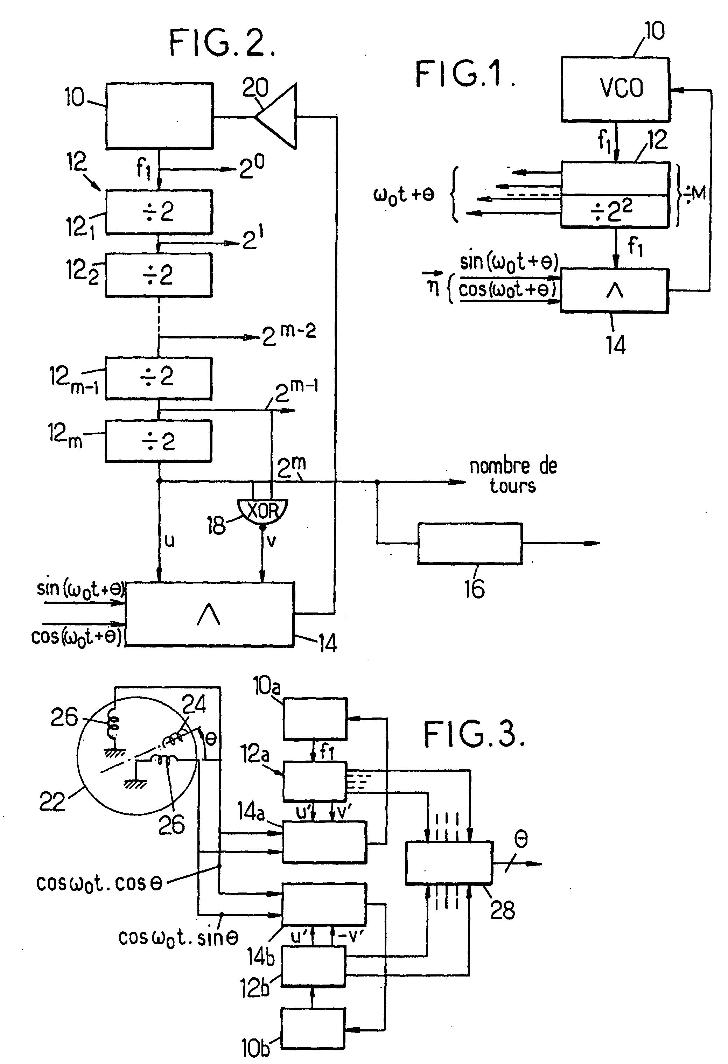

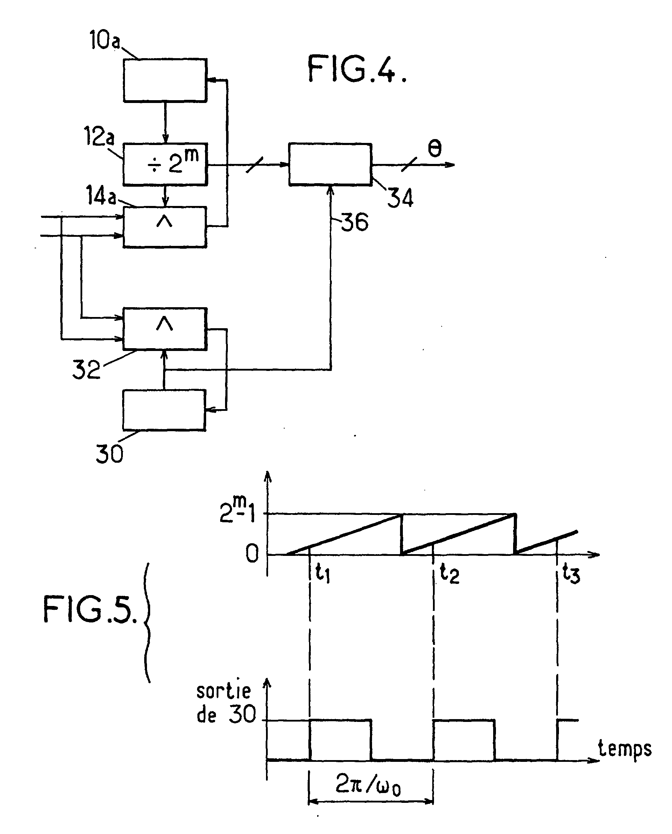

fréquence $\omega_0/2\pi$ dans le cas des figures 3 et 4.

Le dispositif dont la constitution de principe est montrée en figure 1 permet d'obtenir une représentation numérique d'un angle $\omega_0 t+\theta$ à partir de signaux d'entrée représentant respectivement $\sin(\omega_0 t+\theta)$ et $\cos(\omega_0 t+\theta)$. Ce dispositif comprend un convertisseur tension-fréquence 10, constitué généralement par un oscillateur commandé par tension, dit VCO, ayant une plage de fonctionnement qui incorpore la fréquence $N\omega_0/2\pi$. N est choisi en fonction de la résolution $2\pi/N$ que l'on souhaite obtenir.

La sortie du convertisseur 10 attaque un diviseur 12 constitué par une cascade 12, fournissant en sortie un signal carré à fréquence $f_1/N$ où $f_1$ est la fréquence de sortie du convertisseur 10. La cascade peut être constituée par des diviseurs par deux successifs, qui permettront d'obtenir une représentation de l'angle $\omega_0 t+\theta$ sous forme d'un nombre binaire.

La sortie de la cascade 12 peut être représentée par un vecteur ayant des composantes u et v, en phase et en quadrature, où u et v ne peuvent prendre que les valeurs 0 et 1. Ces deux composantes sont appliqués à un multiplieur vectoriel 14 qui reçoit également les grandeurs analogiques représentant $\eta = (\sin(\omega_0 t+\theta), \cos(\omega_0 t+\theta))$.

La fréquence $f_1$ peut être asservie à la valeur $Nf_0 = N\omega_0/2\pi$ en rendant parallèles le vecteur $\eta$ et le vecteur $\eta$ (u',v') issu des composantes en phase et en quadrature u,v de sortie de la cascade 12 selon la formule déjà définie. Pour cela, il faut asservir $f_1$ pour obtenir :

$$(u'/\cos(\omega_0 t+\theta)) = (v'/\sin(\omega_0 t+\theta))$$

La différence $u'.\sin(\omega_0 t+\theta)-v'.\cos(\omega_0 t+\theta)$ constitue un signal d'erreur $\sin\varepsilon$ proportionnel au déphasage entre les deux vecteurs, faible et donc assimilable à $\varepsilon$, permettant de contrôler le convertisseur 10 à la fréquence $f_1 = N.f_0$.

On voit que toutes les fonctions requises sont remplies par un convertisseur tension-fréquence 10, formé par un oscillateur commandé par tension et des portes logiques simples, constituant des diviseurs par deux, et une logique simple de calcul du signal d'erreur, obtenu à partir de deux produits scalaires et d'une soustraction.

Il n'est pas impératif que la cascade réalise une division par une puissance de deux, ni qu'elle soit constituée de diviseurs par deux. Si en particulier on souhaite obtenir une valeur angulaire représentée non par un nombre binaire, mais par une indication en degrés, minutes et secondes, les étages peuvent être prévus pour avoir des rapports de division différents de deux. Il faut cependant terminer par deux divisions par 2.

Le dispositif de la figure 1 peut être implémenté sous la forme montrée en figure 2. La cascade 12 est formée de m étages $12_1$, $12_2$, ..., $12_m$. La sortie du convertisseur 10 et les sorties des étages successifs fournissent les nombres binaires de poids 0,1,...,m-1,m du nombre représentant l'angle $\omega_0 t+\theta$, avec une résolution égale à $2\pi.2^{-m}$. La sortie du dernier étage $12_m$ constitue un compte-tours modulo deux. Des diviseurs par deux supplémentaires peuvent être prévus pour compter un nombre de tours suffisant en donnant une indication modulo 4, 8, ..., N, N étant un entier quelconque.

La composante en phase u peut être prélevée à la sortie de l'étage $12_m$. La composante en quadrature v peut être obtenue à l'aide d'une porte OU exclusif 18 qui reçoit la sortie des étages diviseurs $12_{m-1}$ et $12_m$. On peut également utiliser un compteur donnant la suite 01,11,10,00 (binaire réfléchi).

Le multiplieur vectoriel 14 se réduit alors à deux multiplieurs scalaires et un soustracteur permettant d'obtenir le signal analogique d'erreur

$$u'\sin(\omega_0 t+\theta)\ v'\cos(\omega_0 t+\theta)$$

Après traitement, ce signal est amené à l'entrée de commande du convertisseur tension-fréquence 10.

En général, un réseau correcteur à action intégrale 20 sera prévu sur la boucle de retour.

Le dispositif de mesure de phase à partir d'un vecteur d'entrée $\eta=(\cos\omega_0 t\cos\theta, \cos\omega_0 t\sin\theta)$ peut être constitué en utilisant un ensemble conforme au schéma de la figure 1 en association avec un second ensemble correspondant à un sens de rotation opposé et à un échantillonneur.

La figure 3 montre un tel dispositif de mesure numérique d'un angle $\theta$, appliqué à la fourniture de la valeur numérique d'un angle à partir de signaux analogiques fournis par un résolveur angulaire 22. Un résolveur classique est constitué par un transformateur ayant un primaire et un secondaire portés chacun par un des éléments mobiles en rotation l'un par rapport à l'autre. Le primaire comporte un bobinage unique 24 alimenté par une tension alternative à une fréquence angulaire (pulsation) de porteuse $\omega_0$. Le secondaire comporte deux bobines 26 croisées, fournissant respectivement des signaux proportionnels à $\sin\theta$ et $\cos\theta$, modulant la porteuse à fréquence angulaire $\omega_0$.

Dans le cas illustré sur la figure 3, le dispositif de mesure de l'angle $\theta$ comprend deux ensembles du genre montré en figure 1. L'un des ensembles comprend un convertisseur $10_a$, une cascade $12_a$ formée par exemple de m étages successifs de division par deux, formant un registre, et un multiplieur vectoriel $14_a$. Le second ensemble comprend un convertisseur tension-fréquence $10_b$ et une cascade $12_b$ identique aux éléments correspondants du premier ensemble et un multiplieur vectoriel $14_b$ qui ne se différencie de $14_a$ que par la complémentation logique d'une des sorties de $12_b$ ou le changement de signe de v'.

Dans la variante de réalisation montrée en figure 4, l'ensemble $10_a$, $12_a$, $14_a$, est identique à celui montré en figure 3. En revanche, un second ensemble comprend un convertisseur tension-fréquence 30 destiné à être asservi à la fréquence $\omega_0/2\pi$ et un multiplieur vectoriel 32 destiné à fournir le signal d'erreur.

Un circuit 34 de lecture du contenu des étages de la cascade $12_a$ fournit une sortie chaque fois qu'il reçoit, sur une entrée de commande 36, un signal obtenu par exemple à chaque front de montée du signal de sortie u ou v. On obtient ainsi des lectures successives de $\theta$ aux instants $t_1, t_2, t_3,...$

L'angle $\theta$ dont il est question ici est un angle qu'on peut qualifier d'électrique, en ce sens qu'il peut correspondre à deux angles mécaniques mutuellement supplémentaires.

Dans une version où il est nécessaire de connaître $\theta$ à tout instant, les sorties des étages correspondants des deux cascades peuvent être appliquées à un soustracteur 28 moyennant une gestion des débordements.

Les entrées numériques peuvent respectivement s'écrire $2\pi n_1/2^m$ et $2\pi n_2/2^m$, où $n_1$ et $n_2$ sont les contenus des étages successifs des cascades. Ces contenus représentent respectivement $\omega_0 t + \theta$ et $+ \omega_0 t - \theta$ : la sortie $n_1 - n_2$ du soustracteur représente en conséquence l'angle $8 = (n_1 - n_2)\pi/2^m$ modulo $\pi$.

A titre d'exemple, on peut indiquer qu'un dispositif suivant la figure 3 a été réalisé en adoptant une fréquence $f_0 = \omega_0/2\pi = 3$ KHz et une valeur $2^m = 4096$, ce qui conduit à une fréquence $f_1$ de 12,3 MHz. On peut ainsi mesurer un angle $\theta$ avec une résolution de 0,04°, soit à peut près 2,6 minute d'angle.

## Revendications

**1.** Dispositif de mesure à sortie numérique, destiné à recevoir deux signaux analogiques d'entrée représentables par un vecteur de la forme

$$\eta = (\cos(\omega_0 t + \theta), \sin(\omega_0 t + \theta))$$

où $\omega_0$ est une pulsation et $\theta$ une phase, comprenant au moins un premier ensemble (10,12,14) ayant :

- un convertisseur tension/fréquence (10) ayant une plage de fonctionnement contenant la fréquence $N\omega_0/2\pi$, où N est un entier positif,
- un diviseur (12) ayant des étages successifs en cascade, recevant le signal de sortie du convertisseur à une fréquence $f_1$ et fournissant deux composantes en phase et en quadrature u et v, prenant les valeurs 0 et 1, à la fréquence du convertisseur divisée par N,
- un multiplieur vectoriel (14) du signal d'entrée $\eta$ par un vecteur $\hat{\eta}$ de composantes u' 2u-1, v'

2v-1.

- une boucle d'asservissement de la fréquence $f_1$ du convertisseur à partir d'une tension constituant un signal d'erreur apparaissant à la sortie du multiplieur vectoriel (14), les sorties des étages successifs de la cascade fournissant une représentation numérique de $\omega_0 t + \theta$, avec une résolution $2\pi/N$.

**2.** Dispositif selon la revendication 1, **caractérisé en ce que** la cascade est constituée d'étages diviseurs par deux ($12_1,...,12_m$), où m est un entier positif.

**3.** Dispositif selon la revendication 1 ou 2, **caractérisé en ce que** le multiplieur vectoriel (14) comprend deux multiplieurs scalaires et un additionneur ou soustracteur.

**4.** Dispositif selon la revendication 2, **caractérisé en ce que** le multiplieur vectoriel (14) comporte une entrée recevant la sortie du dernier étage de la cascade et une entrée recevant le résultat d'une opération logique OU EXCLUSIF (XOR) entre les sorties du dernier et de l'avant dernier étage de la cascade .

**5.** Dispositif de mesure selon l'une quelconque des revendications précédentes, destiné à fournir l'angle de phase $\Theta$, comprenant de plus:

un second ensemble ($10_b$, $12_b$, $14_b$) identique audit premier ensemble ($10_a$, $12_a$, $14_a$) mais avec une valeur opposée de v', les convertisseurs ($14_a$, $14_b$) des deux ensembles recevant l'un et l'autre deux signaux de la forme $\cos\omega_0 t \cos\Theta$ et $\cos\omega_0 t \sin\Theta$, et un soustracteur (28) recevant les sorties des étages correspondants des diviseurs du premier ensemble ($10_a$, $12_a$, $14_a$) et du second ensemble ($10_b$, $12_b$, $14_b$), le soustracteur (28) fournissant une représentation numérique de $\Theta$.

**6.** Dispositif de mesure selon l'une quelconque des revendications 1 à 4, permettant d'obtenir l'angle de phase $\Theta$, comprenant de plus:

un second ensemble ayant un second convertisseur tension-fréquence (30) et un multiplieur vectoriel (32) destiné à asservir le second convertisseur (30) à la fréquence $\omega_0/2\pi$, et un lecteur (34) du contenu de la cascade ($12_a$) dudit premier ensemble ($10_a$, $12_a$, $14_a$) en réponse à un front de montée ou de descente de la sortie du second convertisseur tension-fréquence (30) à fréquence $\omega_0/2\pi$ les convertisseurs ($14_a$, 30) des deux ensembles recevant l'un et l'autre deux signaux de la forme $\cos\omega_0 t \cos\Theta$ et $\cos\omega_0 t \sin\Theta$, le lecteur (34) fournissant une représentation numérique de $\Theta$.

**Patentansprüche**

1. Meßvorrichtung mit einem digitalen Ausgang, welche zum Empfang von zwei analogen Eingangssignalen bestimmt ist, welche durch einen Vektor der Form

$$\eta = (\cos(\omega_0 t + \theta),\ \sin(\omega_0 t + \theta))$$

dargestellt sind, wobei $\omega_0$ eine Winkelgeschwindigkeit und $\theta$ eine Phase ist, umfassend wenigstens eine erste Anordnung (10, 12, 14) mit:

- einem Spannungs-/Frequenz-Wandler (10) mit einem Funktionsbereich, der die Frequenz $N\omega_0/2\pi$ enthält, wobei N eine positive ganze Zahl ist;
- einer Teilungseinrichtung (12) mit zwei aufeinander folgenden kaskadenartigen Stufen, die das Ausgangssignal des Wandlers mit einer Frequenz $f_1$ empfängt und zwei Komponenten in Phase und um 90° phasenverschoben, u und v, bildet, welche die Werte 0 und 1 annehmen, und zwar mit der Frequenz des Wandlers geteilt durch N;
- einer vektoriellen Multiplikationseinrichtung (14) zum Multiplizieren des Eingangssignals $\eta$ mit einem Vektor $\hat{\eta}$ mit den Komponenten u' = 2u - 1, v' = 2v - 1;
- einem Steuerkreis für die Frequenz $f_1$ des Wandlers auf der Grundlage einer Spannung, die ein Fehlersignal bildet, das am Ausgang der vektoriellen Multiplikationseinrichtung (14) auftritt, wobei die Ausgänge der auseinanderfolgenden kaskadenförmigen Stufen eine digitale Darstellung von $\omega_0 t + \theta$ mit einer Auflösung von $2\pi/N$ liefern.

2. Vorrichtung nach Anspruch 1, **dadurch gekennzeichnet, daß** die Kaskade aus Stufen zur Teilung durch zwei ($12_1$, ..., $12_m$) gebildet ist, wobei m eine positive ganze Zahl ist.

3. Vorrichtung nach Anspruch 1 oder 2, **dadurch gekennzeichnet, daß** die vektorielle Multiplikationseinrichtung (14) zwei skalare Multiplikationseinrichtungen und eine Additions- oder Subtraktionseinrichtung umfaßt.

4. Vorrichtung nach Anspruch 2, **dadurch gekennzeichnet, daß** die vektorielle Multiplikationseinrichtung (14) einen Eingang umfaßt, der den Ausgang der vorhergehenden kaskadenförmigen Stufe empfängt sowie einen Eingang, der das Ergebnis einer logischen exklusiven ODER-Operation (XOR) zwischen den Ausgängen der vorhergehenden und der vor der vorhergehenden liegenden kaskadenförmigen Stufe empfängt.

5. Meßvorrichtung nach einem der vorhergehenden Ansprüche, welche zur Bildung eines Phasenwinkels θ bestimmt ist, ferner umfassend:

eine zweite Anordnung ($10_b$, $12_b$, $14_b$) identisch zu der ersten Anordnung ($10_a$, $12_a$, $14_a$), jedoch mit einem entgegengesetzten Wert v', wobei die Wandler ($14_a$, $14_b$) der beiden Anordnungen beide zwei Signale der Form $\cos\omega_0 t \cos\theta$ und $\cos\omega_0 t \sin\theta$ empfangen, und eine Substraktionseinrichtung (28), welche die Ausgänge der entsprechenden Stufen der Teilungseinrichtungen der ersten Anordnung ($10_a$, $12_a$, $14_a$) und der zweiten Anordnung ($10_b$, $12_b$, $14_b$) empfängt, wobei die Substraktionseinrichtung (28) eine digitale Darstellung von θ bildet.

6. Meßvorrichtung nach einem der Ansprüche 1 bis 4, welche ermöglicht, einen Phasenwinkel θ zu erhalten, ferner umfassend:

eine zweite Anordnung mit einem zweiten Spannungs-Frequenz-Wandler (30) und einer vektoriellen Multiplikationseinrichtung (32), welche zur Steuerung des zweiten Wandlers (30) mit einer Frequenz $\omega_0/2\pi$ bestimmt ist, und eine Leseeinrichtung (34) zum Lesen des Inhalts der Kaskade ($12_a$) der ersten Anordnung ($10_a$, $12_a$, $14_a$) in Antwort auf eine ansteigende oder abfallende Flanke des Ausgangs des zweiten Spannungs-Frequenz-Wandlers (30) mit einer Frequenz $\omega_0/2\pi$, wobei die Wandler ($14_a$, 30) der zwei Anordnungen beide zwei Signale der Form $\cos\omega_0 t \cos\theta$ und $\cos\omega_0 t \sin\theta$ empfangen, wobei diese Leseeinrichtung (34) eine digitale Darstellung von θ bildet.

**Claims**

1. A measuring device having a digital output and adapted to receive two input analog signals representable by a vector having the form

$$\eta = (\cos(\omega_0 t + \theta),\ \sin(\omega_0 t + \theta))$$

where $\omega_0$ is a pulsation and θ is a phase, the device comprising at least one first assembly (10, 12, 14) comprising:

- a voltage/frequency converter (10) having a range of operation containing the frequency $N\omega_0/2\pi$ where N is a positive integer,

- a divider (12) having successive stages in cascade, receiving the output signal from the converter at a frequency $f_1$ and supplying two components u and v in phase and in quadrature, taking the values 0 and 1 at the converter frequency divided by N,

- a vectorial device (14) for multiplying the input signal $\eta$ by a vector $\eta$ having the components u' = 2u-1, v' = 2v-1, and

- a loop for controlling the frequency $f_1$ of the converter on the basis of a voltage comprising an error signal appearing at the output of the vectorial multiplier (14), the outputs of the successive stages of the cascade providing a digital representation of $\omega_0 t + \theta$ having a resolution $2\pi/N$.

2. A device according to claim 1, **characterised in that** the cascade is made up of stages dividing by two ($12_1$ ... $12_m$) where m is a positive integer.

3. A device according to claim 1 or 2, **characterised in that** the vectorial multiplier (14) comprises two scalar multiplier and an adder or subtractor.

4. A device according to claim 2, **characterised in that** the vectorial multiplier (14) comprises an input receiving the output of the last stage of the cascade and an input receiving the result of an exclusive OR (XOR) logic operation between the outputs of the last and the penultimate stage of the cascade.

5. A measuring device according to any of the preceding claims and adapted to supply the phase angle $\Theta$, also comprising:

    a second assembly ($10_b$, $12_b$, $14_b$) identical with the first assembly ($10_a$, $12_a$, $14_a$) but with an opposite value of v', the converters ($14_a$, $14_b$) of the two assemblies each receiving two signals having the form $\cos\omega_0 t \cos\Theta$ and $\cos\omega_0 t \sin\Theta$, and
    a subtractor (28) receiving the outputs of the corresponding stages of the dividers in the first assembly ($10_a$, $12_a$, $14_a$) and the second assembly ($10_b$, $12_b$, $14_b$), the subtractor (20) providing a digital representation of $\Theta$.

6. A measuring device according to any of claims 1 to 4 and for obtaining the phase angle $\Theta$, also comprising:

a second assembly having a second voltage-frequency converter (30) and a vectorial multiplier (32) for controlling the second converter (30) at the frequency $\omega_0/2\pi$, and
a reader (34) of the contents of the cascade ($12_a$) of the first assembly ($10_a$, $12_a$, $14_a$) in response to a rising or descending front of the output of the second voltage-frequency converter (30) at the frequency $\omega_0/2\pi$, the converters ($14_a$, 30) of the two assemblies each receiving two signals in the form $\cos\omega_0 t \cos\Theta$ and $\cos\omega_0 t \sin\Theta$, the reader (34) supplying a digital representation of $\Theta$.

FIG.2.

FIG.1.

FIG.3.

FIG.4.

FIG.5.